# EUROPEAN PATENT SPECIFICATION

(11) **EP 1 589 085 B1**
(45) Date of publication and mention of the grant of the patent: **21.05.2008**
(21) Application number: 04703878.1
(22) Date of filing: 21.01.2004
(51) Int. Cl.: C08F 10/02, H01L 21/02, H01L 21/301, H01L 21/304

(54) **PRESSURE SENSITIVE ADHESIVE SHEET, METHOD OF PROTECTING SEMICONDUCTOR WAFER SURFACE AND METHOD OF PROCESSING WORK**
HAFTFOLIE, SCHUTZVERFAHREN FÜR HALBLEITERWAFEROBERFLÄCHE SOWIE BEARBEITUNGSVERFAHREN
FEUILLE D'ADHESIF AUTOCOLLANT, PROCEDE DE PROTECTION DE SURFACE DE PLAQUETTE A SEMICONDUCTEUR ET PROCEDE DE TRAITEMENT

(30) Priority: 22.01.2003 JP 2003013462
(43) Date of publication of application: 26.10.2005
(73) Proprietor: Lintec Corporation, Tokyo 173-0001 (JP)
(72) Inventor: HORIGOME, Katsuhiko, 81925 Munich (DE); IZUMI, Tatsuya, Saitama-shi, Saitama 336-0026 (JP); TAKAHASHI, Kazuhiro, Kawaguchi-shi, Saitama 333-0866 (JP)
(74) Representative: Towler, Philip Dean
(86) International application number: PCT/JP2004/000450
(87) International publication number: WO 2004/065510

(56) References cited:
- JP-A- 5 211 234
- JP-A- 62 271 451
- JP-A- 2001 348 539

## Description

### Technical Field

The present invention relates generally to pressure sensitive adhesive sheets, and more particularly to pressure sensitive adhesive sheets that can be used as surface protective sheets, dicing sheets or pickup sheets and suitably applied to manufacturing processes including heat treatment or treatment involving heat generation after attachment to semiconductor wafers.

### Background Art

In a process for manufacturing semiconductor devices, pressure sensitive adhesive sheets such as surface protective sheets or dicing sheets are used in a backside grinding process or a dicing process. Heat resistance has been not required for the pressure sensitive adhesive sheets for use in these applications, because when pressure sensitive adhesive sheets are applied to semiconductor wafers, washing water has been used to prevent an increase in the temperature during the processing.

EP-A-1002845 describes a pressure-sensitive adhesive sheet for protecting a semiconductor wafer during the grinding step.

Recently, it has been proposed to form circuitry on both sides of semiconductor wafers to enhance the integration density. In this case, after finishing backside grinding, wafers are subjected to processing such as circuitry formation on the ground side of wafers, while the wafers are being held on surface protecting sheets. Various treatments that involve heating such as etching are performed for the circuitry formation. Consequently, surface protective sheets are also exposed to the heat.

However, conventional surface protective sheets using soft base materials occur melting or softening of the base materials by heating and adhesion of the base materials to the holding part of an etching apparatus.

Therefore, surface protective sheets in which the base materials do not adhere to other apparatuses by heating are required.

In order to eliminate such problems as adhesion by heating, the use of rigid films with a high melting point such as polyethylene terephthalate or polyethylene naphthalate has been proposed. However, these rigid films are inferior in protective performance of the circuit surface. Moreover, even these high-melting-point films sometimes have suffered from shrinkage by heating to cause warpage of wafers after processing.

Moreover, after the backside grinding of semiconductor wafers, it has been proposed to form films having various functions such as insulating films or anisotropic conductive adhesive layers on the backside of wafers or on the circuit surface. Films having these functions are formed on the wafers by thermo-compression bonding of functional films comprised of thermo-adhesive films. At this time, when the wafer is thin and thus easily broken by pressure, the formation of the films may be performed in a configuration where the opposite side of the wafer is applied with a pressure sensitive adhesive sheet such as a surface protective sheet or a dicing sheet to reinforce the wafer.

However, the pressure sensitive adhesive sheets to be used for processing semiconductor wafers at a high temperature are hardly known to date. After diligent study, the present inventors have found that the heat resistance is improved by using highly crosslinked films instead of thermoplastic films such as polyolefin or the like as the base materials for use in the pressure sensitive adhesive sheets. The structure of each of these pressure sensitive adhesive sheets is disclosed by the present applicant, for example, in Japanese Patent Laid-Open No. 9-253964, Japanese Patent Laid-Open No. 10-337823, and Japanese Patent Laid-Open No. 2002-141306.

However, even for these pressure sensitive adhesive sheets, there has remained a problem of heat-adhesion to a heated table (wafer-holding part), when the base materials are adjusted to be soft in order to impart protective properties for circuit surfaces or expanding properties.

The present invention has been made in view of the above described prior arts, and an object of the present invention is to provide a pressure sensitive adhesive sheet that does not adhere to other apparatuses and the like, even when it is applied to a manufacturing including heat treatment or treatment involving heat generation. It is a further object of the present invention to provide a pressure sensitive adhesive sheet for semiconductor wafer processing or the like having unprecedented high-temperature resistance, which can be used as a surface protective sheet, a dicing sheet or a pickup sheet, by imparting properties such as protective function of a circuit surface or expanding properties.

### Disclosure of Invention

A pressure sensitive adhesive sheet according to the present invention is characterized by comprising a base material obtained by film-forming and curing a first curable resin, a top coat layer 0.2 to 20 µm thick formed on the base material by coating and curing a second curable resin, and a pressure sensitive adhesive layer formed on the opposite side of the base material, wherein a cured resin forming the top coat layer has no peak of 0.1 J/g or more in the DSC measurement from 50 to 200°C.

In addition, the above described base material preferably has a Young's modulus of 50 to 5,000 MPa.

A method for protecting the surface of a semiconductor wafer according to the present invention is characterized by comprising the steps of applying the above described pressure sensitive adhesive sheet to the circuit surface of a semiconductor wafer having circuitry formed on the front side, and grinding the backside of the semiconductor wafer.

In the method for protecting the surface of a semiconductor wafer according to the present invention, a semiconductor wafer applied with a pressure sensitive adhesive sheet can be subjected to heat treatment or treatment involving heat generation before or after grinding the semiconductor wafer.

Here, the heat treatment may include, for example, thermo-compression bonding of a thermo-adhesive film on the ground side of a semiconductor wafer. Moreover, the treatment involving heat generation may include, for example, the treatment selected from vacuum deposition, sputtering and plasma etching applied to the ground side of a semiconductor wafer.

A method for processing a workpiece according to the present invention is characterized by comprising the steps of fixing a workpiece with the above described pressure sensitive adhesive sheet and picking up the workpiece.

Moreover, a workpiece applied with a pressure sensitive adhesive sheet may be subjected to heat treatment or treatment involving heat generation, before the picking up of the workpiece.

In particular, the present invention realizes a method for processing a workpiece wherein a workpiece fixed to a pressure sensitive adhesive sheet is applied with a thermo-adhesive film by thermo-compression bonding; the workpiece is diced together with the thermo-adhesive film; and then the diced workpiece is picked up and thermally adhered to a substrate via the thermo-adhesive film. Best Mode for Carrying Out the Invention

The present invention will now be described in further detail below.

The pressure sensitive adhesive sheet according to the present invention is composed of a base material, a top coat layer formed thereon and a pressure sensitive adhesive layer formed on the opposite side thereof. The base material, the top coat layer and the pressure sensitive adhesive layer will be described in detail below.

### (Base material)

The base material is made of a film obtained by film-forming and curing a first curable resin to be described below. The film desirably has a Young's modulus of from 50 to 5,000 MPa, preferably from 60 to 4,000 MPa, most preferably from 80 to 3,000 MPa. Moreover, the thickness of the base material is preferably from 1 to 1,000 µm, more preferably from 10 to 800 µm, most preferably from about 20 to 500 µm but not restricted thereto.

Energy ray-curable resins, thermosetting resins or the like are used as a first curable resin to be used as a raw material for the base material, and energy ray-curable resins are preferably used. If the base material is prepared by curing a curable resin, the base material will become less susceptible to temperature-induced deformation such as melting by heating, and its heat resistance is improved.

For example, a resin composition mainly composed of an energy-ray polymerizable urethane acrylate oligomer is suitably used as an energy ray-curable resin. The molecular weight of the urethane acrylate oligomer suitably used in the present invention ranges from 1,000 to 50,000, more preferably from 2,000 to 30,000. The urethane acrylate oligomer can be used singly or in combination of two or more.

It is often difficult to form a film only by the above described urethane acrylate oligomer. Therefore, the urethane acrylate oligomer is generally diluted with an energy ray-polymerizable monomer and processed into film-form, thereby cured to obtain a film. The energy ray-polymerizable monomer has an energy ray-polymerizable double bond in its molecule, and particularly acrylate compounds having a relatively bulky group such as isobornyl (meth)acrylate, dicyclopentenyl (meth)acrylate, and phenyl hydroxypropyl acrylate are suitably used in the present invention.

The above described energy ray-polymerizable monomer is used in a ratio of preferably from 5 to 900 parts by weight, more preferably from 10 to 500 parts by weight, most preferably from 30 to 200 parts by weight, per 100 parts by weight of the urethane acrylate oligomer.

When forming the base material from the above described energy ray-curable resin, the time of polymerization and curing by energy-ray irradiation, and the amount of irradiation can be reduced by incorporating a photopolymerization initiator into the resin.

The photopolymerization initiator is used in an amount of preferably from 0.05 to 15 parts by weight, more preferably from 0.1 to 10 parts by weight, most preferably from 0.5 to 5 parts by weight, per 100 parts by weight of the total resin.

The above described curable resin can be selected from various combinations of oligomers and monomers formulated so as to have above described Young's modulus.

Moreover, the above described resin may contain additives including inorganic fillers such as calcium carbonate, silica and mica; metallic fillers such as iron and lead; colorants such as pigments and dye; and the like.

A method of forming the base material comprises casting a first curable resin in liquid-form on a process film into thin film-form, converting it into a film by predetermined means and removing the process film. This method reduces the stress applied to a resin during film-forming and minimizes dimensional changes with the lapse of time or heating. Moreover, as solid impurities are easily removed, formation of fish eyes in the formed film is reduced. Thereby, the uniformity of film thickness is improved, resulting in a thickness accuracy of generally within 2%.

Moreover, both sides of the base material, that is, the surface on which a top coat layer is formed and another surface on which a pressure sensitive adhesive layer is formed, may be subjected to corona treatment or primer treatment to form another layer to thereby enhance bonding strength to these layers.

The film formed from the raw materials and by the method as described above may exhibit properties excellent in stress relaxation properties. When a film excellent in stress relaxation properties is used as the base material for a pressure sensitive adhesive sheet, the residual stress to be generated when applied to an adherend can be quickly eliminated and does not adversely affect the subsequent processing. Therefore, when the pressure sensitive adhesive sheet is used for protecting a semiconductor wafer that is subjected to grinding to an extra-thin thickness, the semiconductor wafer does not exhibit warpage because of the stress relaxation.

The stress relaxation properties of the base material are specifically represented by the percentage of stress relaxation after one minute at 10% elongation in a tensile test, and it is preferably 40% or more, more preferably 50% or more, most preferably 60% or more. The higher percentage of stress relaxation of the base material is more preferable, and its upper limit, which is theoretically 100%, may be 99.9%, 99% or 95%.

### (Top coat layer)

A top coat layer is coated on one side of a base material and further improves the heat resistance of the base material. The top coat layer is obtained by film-forming and curing of a second curable resin.

The cured top coat layer has no peak of 0.1 J/g or more in the DSC (differential scanning calorimetry) measurement from 50 to 200°C. If there is a peak in the DSC measurement (generation or absorption of heat occurs), the top coat layer may be easily deformed by heating to increase the contact area, resulting in adhesion to a heater plate or the like.

Moreover, a rough surface of the top coat layer is preferred, because it can reduce the contact area with a heater plate and further prevent the adhesion during heating. The top coat layer has a surface roughness Rz of preferably from 0.05 to 1.0 µm, more preferably from 0.1 to 0.5 µm. If the top coat layer is too rough, it may be slippery and may impair workability in some steps of wafer processing.

Energy ray-curable resins, thermosetting resins or the like are used as a second curable resin for forming such a top coat layer, similar to the first curable resin used for forming the base material, and energy ray-curable resins are preferably used. It is preferable to select the second curable resin such that it has a higher crosslinking density after curing than that of the first curable resin. This minimizes the occurrence of generation or absorption of heat in the DSC measurement.

When the energy ray-curable resin is used as the second curable resin, it is preferable to increase the content of a multifunctional energy ray-curable compound having low molecular weight. Such energy ray-curable compounds to be used include, for example, trimethylolpropane triacrylate, pentaerythritol triacrylate, pentaerythritol tetraacrylate, dipentaerythritol monohydroxy pentaacrylate, and dipentaerythritol hexaacrylate.

When the second curable resin is composed of the multifunctional energy ray-curable compound having low molecular weight, the adhesion to the base material may decrease. For improving the adhesion to the base material, a binder component may be added in the second curable resin. The use of the binder component may cause generation or absorption of heat in the DSC measurement caused by a polymer in the binder. However, if the binder component and the energy ray-curable compound are sufficiently compatible, the micro-molecular motion of the binder component after curing can be suppressed, and the amount of heat generation or heat absorption can be reduced, to thereby prevent the adhesion to a heater plate or the like. Examples of such binder components include acrylic resins, polyester resins, urethane resins and polyamide resins.

Moreover, the second curable resins may be polymers having an energy ray curable-functional group on the side chain. The use of these polymers as second curable resins can improve the adhesion to base materials without reducing crosslinking density. The polymers that can be used may include, for example, those having a main chain of acrylic polymer and a side chain of an energy ray-curable double bond or an epoxy group as a functional group.

The surface roughness of the top coat layer can be appropriately adjusted by the amount of fillers to be added. The fillers to be used include, for example, inorganic fillers such as calcium carbonate, silica and mica; and metallic fillers such as iron and lead. The surface roughness is increased by increasing the amount of the fillers. The amount of the fillers to be added is different depending on the type of the fillers, and suitable amount is generally from 0 to 200 parts by weight, more preferably from about 5 to 100 parts by weight, per 100 parts by weight of the curable resin.

The top coat layer can be formed by directly film-forming and curing the second curable resin on the above described base material. In addition, a base material with a top coat layer can be formed by casting the second curable resin in liquid-form on a casting film and further casting a first curable resin thereon. The curing of the top coat and the base material may be performed immediately after each film-forming or may be performed together after the film-forming of the base material. When the top coat is formed by casting, the surface roughness depends on the roughness of a casting film, so it is preferable to select a casting film having appropriate roughness.

The thickness of the top coat layer is from 0.2 to 20 µm, most preferably from about 0.5 to 5 µm.

### (Pressure sensitive adhesive layer)

In the pressure sensitive adhesive sheet of the present invention, a pressure sensitive adhesive layer is formed on the surface of a base material opposite to the surface on which a top coat layer is formed.

The pressure sensitive adhesive layer may be formed from strong pressure sensitive adhesives for general purpose use, energy ray-curable pressure sensitive adhesives frequently used for wafer processing, or removable pressure sensitive adhesives for general purpose use. It is preferable to form the pressure sensitive adhesive layer by the energy ray curable-pressure sensitive adhesives particularly in the present invention.

Generally, such energy ray-curable pressure sensitive adhesives are mainly composed of acrylic pressure sensitive adhesives and energy ray-curable compounds.

Low molecular weight compounds having two or more energy ray-polymerizable carbon-carbon double bonds in its molecule which can form three-dimensional network by photoirradiation as disclosed for example in Japanese Patent Laid-Open No. 60-196956 and Japanese Patent Laid-Open No. 60-223139 are widely used as the energy ray-curable compounds for the energy ray-curable pressure sensitive adhesives. Specifically, trimethylolpropane triacrylate, pentaerythritol triacrylate, pentaerythritol tetraacrylate, dipentaerythritol monohydroxy pentaacrylate, dipentaerythritol hexaarylate, 1,4-butyleneglycol diacrylate, 1,6-hexanediol diacrylate, polyethyleneglycol diacrylate, or oligomers such as oligoester acrylates or urethane acrylates are used.

The compounding ratio of the energy ray-polymerizable compound to the acrylic pressure sensitive adhesive in the energy ray-curable pressure sensitive adhesive is preferably from 50 to 200 parts by weight of the energy ray-polymerizable compound per 100 parts by weight of the acrylic pressure sensitive adhesive. When they are used in these ranges, the resultant pressure sensitive adhesive sheet has large initial adhesive strength, and the adhesive strength sharply decreases after energy-ray irradiation. Therefore, the pressure sensitive adhesive sheet can be easily removed from an adherend by energy-ray irradiation.

Moreover, energy ray-curable pressure sensitive adhesive layers may be formed from energy ray-curable copolymers having energy ray-polymerizable groups on the side chain. These energy ray-curable copolymers have both tackiness and energy ray-curability. The details of the energy ray-curable copolymers having energy ray-polymerizable groups on the side chain are disclosed, for example, in Japanese Patent Laid-Open No. 5-32946 and Japanese Patent Laid-Open No. 8-27239.

The pressure sensitive adhesive layer has a thickness, which varies depending on materials, of generally from about 3 to 100 µm, preferably from about 10 to 50 µm.

The pressure sensitive adhesive sheet of the present invention can be obtained using generally known coaters such as roll coaters, knife coaters, roll-knife coaters, reverse coaters and die coaters, wherein the pressure sensitive adhesive layer is formed by coating and drying the above described pressure sensitive adhesives so as to have a suitable thickness on the base material opposite to the top coat layer, or the pressure sensitive adhesive layer is formed on a release sheet and transferred to the surface of the base material.

Next, methods for processing workpieces according to the present invention will be described, taking a method for protecting surfaces, a dicing method and a pickup method, particularly for processing semiconductor wafers, as examples. However, in the present invention, the workpieces to be processed are not limited to semiconductor wafers. For example, the present invention can be applied to the processing of various ceramics, glass, metal or the like.

### (Method for protecting surfaces)

The pressure sensitive adhesive sheet according to the present invention has a specific top coat layer formed on one surface of the base material, as described above. This top coat layer has high heat resistance. Therefore, even in the case where the pressure sensitive adhesive sheet is applied to a process including the treatment involving heat treatment, if the top coat layer is placed in contact with the member that has high temperature in an apparatus or the like (a sample table in etching or the bottom of an oven), the pressure sensitive adhesive sheet will not adhere to these apparatuses.

Such pressure sensitive adhesive sheets can be used even in the manufacturing of semiconductor wafers including heat treatment or treatment involving heat generation in which the application of pressure sensitive adhesive sheets has been conventionally impossible.

More specifically, the pressure sensitive adhesive sheets can be suitably applied to manufacturing processes such as (1) and (2) as described below as surface protective sheets for semiconductor wafers.

### (1) Surface protective sheets in the treatment involving heat generation such as plasma etching to the ground surface of semiconductor wafers

In some cases, semiconductor wafers are subjected to plasma etching after backside grinding in order to remove a debris layer which may cause package crack. For performing plasma etching, semiconductor wafers with pressure sensitive adhesive sheets for protecting surfaces thereon are sent to a plasma etching apparatus so as to prevent breakage during transportation, because semiconductor wafers are often ground to extremely thin thickness. The semiconductor wafers generate heat to approximately 180°C at the etching, resulting in heating pressure sensitive adhesive sheets too. If conventional pressure sensitive adhesive sheets are used as surface protective sheets, base materials may melt or soften to cause the pressure sensitive adhesive sheets to be adhered to a sample table in the etching apparatus. However, when the pressure sensitive adhesive sheet of the present invention is used as a surface protective sheet, neither a base material nor a top coat layer melts, and the top coat layer is hard to be softened, so that the pressure sensitive adhesive sheet will not cause fusion or adhesion on the sample table of the etching apparatus.

As a typical manufacturing, the pressure sensitive adhesive sheet for protecting surfaces is applied on the circuit surface of a semiconductor wafer on which circuitry is formed, and the semiconductor wafer is ground to a predetermined thickness by a grinding apparatus. The semiconductor wafer is transferred to the plasma etching apparatus to remove the debris layer formed on the ground surface by etching, without removing the pressure sensitive adhesive sheet. Thereafter, the semiconductor wafer is taken out of the plasma etching apparatus, diced by a predetermined process, and packaged to manufacture a semiconductor device.

The treatment involving heat generation other than the plasma etching includes processes for forming films by physical deposition such as vacuum deposition or sputtering, or by CVD process.

### (2) Surface protective sheets in the lamination of thermo-adhesive resin films

In some cases, resin films are provided on the backside of wafers, in order to impart sufficient strength to wafers (finally chips), or to improve adhesion with mold resins, or to be used for bonding to lead frames. The resin film may be formed on the wafer by a spin coater, or may be laminated to the wafer by applying a film having thermo-adhesive properties to the wafer by thermo-compression bonding using a heater roller or the like. Since for example a thermoplastic polyimide , having heat resistance is typically used as the thermo-adhesive resin film, heating to approximately 180°C is adopted as the condition of the thermo-compression bonding. During the thermo-compression bonding, the circuit surface in contact with the surface of a fixed table is protected by applying the pressure sensitive adhesive sheet for protecting surfaces. If a conventional pressure sensitive adhesive sheet is used as a surface protective sheet, a base material may melt or soften to cause adhesion of the pressure sensitive adhesive sheet to a fixed table. However, when the pressure sensitive adhesive sheet of the present invention is used as a surface protective sheet, neither a base material nor a top coat layer melts, and the top coat layer is hard to be softened, so that the pressure sensitive adhesive sheet will not cause fusion or adhesion on the fixed table.

As a typical manufacturing, the pressure sensitive adhesive sheet for protecting surfaces is applied on the circuit surface of a semiconductor wafer on which circuitry is formed, and the semiconductor wafer is ground to a predetermined thickness by a grinding apparatus. The semiconductor wafer is transferred to a laminator capable of heat treatment without removing the pressure sensitive adhesive sheet to undergo thermo-compression bonding of a desired thermo-adhesive resin film on a desired portion of the semiconductor wafer. Then, the semiconductor wafer is taken out of the laminator, diced in a predetermined process, and packaged to manufacture a semiconductor device.

### (Dicing method, Pickup method)

Moreover, the pressure sensitive adhesive sheet of the present invention can be suitably applied to manufacturing processes such as (3) and (4) as a dicing sheet or a pickup sheet as described below.

### (3) Dicing sheets in a process to form anisotropic conductive adhesive films

When semiconductor chips are mounted on chip substrates by a flip-chip bond system, there is a method securing the conduction between the chips and the substrates by anisotropic conductive adhesive films. In such a case, the anisotropic conductive film may be formed on the substrate side, but it is preferable to provide it on the wafer side because the anisotropic conductive adhesive film can be cut into a chip size at the same time as the chip-dicing in a dicing process.

When the thickness of the wafer is thin, a dicing sheet is applied on the ground surface after grinding the backside of the wafer, and then a protective sheet is removed from the circuit surface of the wafer, so as to prevent the breakage of the wafer. The anisotropic conductive adhesive film will be formed on the circuit surface of the wafer while the dicing sheet is applied on the ground surface. When the anisotropic conductive adhesive film is formed on the circuit surface of the wafer, the film is thermally bonded to follow the irregularity of the circuit surface to thereby bonding thereon, so as to prevent formation of the remaining air (void) at the interface between the film and the irregularity of the circuit surface. The dicing sheet side is brought into contact with a heating table at the thermo-compression bonding. Therefore, as for a conventional dicing sheet, its base material may melt or soften to cause adhesion of the pressure sensitive adhesive sheet to a heating table.

However, when the pressure sensitive adhesive sheet of the present invention is used as a dicing sheet, neither a base material nor a top coat layer melts, and the top coat layer is hard to be softened, so that the pressure sensitive adhesive sheet will not cause fusion or adhesion on the heating table.

As a typical manufacturing, the pressure sensitive adhesive sheet for protecting surfaces is applied on the circuit surface of a semiconductor wafer and its backside is ground to a predetermined thickness, and then the pressure sensitive adhesive sheet for dicing is applied on the ground surface. The pressure sensitive adhesive sheet for protecting surfaces is removed from the circuit surface of the wafer, and the semiconductor wafer in this state is transferred to a laminator capable of heat treatment to undergo thermo-compression bonding of the anisotropic conductive adhesive film on the circuit surface of the wafer. Then, the semiconductor wafer is taken out of the laminator, diced together with the anisotropic conductive adhesive film to be converted to chips. The chips are subjected to flip-chip bonding to substrates via the anisotropic conductive adhesive film and then packaged to manufacture a semiconductor device.

By the way, the present invention is not limited to the lamination of the anisotropic conductive adhesive film, but can be applied to the process for providing an insulating thermo-adhesive film. In this case, the thermo-adhesive film is allowed to flow at flip-chip bonding to bring the chip into contact with the electrode of a substrate for conduction.

### (4) Dicing sheets in a transfer process of wafers (chips) using heat-releasable sheets (pickup sheets)

When semiconductor wafers are ground to an extreme thinness with fixing the wafers to hard plates such as glass, the accuracy of thickness can be improved, and the breakage can be prevented. In such a case, typically, the wafers are fixed on the hard plates by double-sided pressure sensitive adhesive sheets. In order to facilitate the removal of the wafers from the hard plates after finishing the grinding, heat-deformable pressure sensitive adhesive sheets are used as the double-sided pressure sensitive adhesive sheets. Various heat-deformable pressure sensitive adhesive sheets have been devised. As an example, heat-shrinkable properties are utilized to deform a pressure sensitive adhesive sheet to reduce the contact area with a wafer to facilitate the removal of the wafer (e.g., Adwill N series made by Lintec Corporation). As another example, there is a double-sided pressure sensitive adhesive sheet using a heat-expandable pressure sensitive adhesive as a pressure sensitive adhesive layer (e.g., REVALPHA made by Nitto Denko Corporation), in which the pressure sensitive adhesive layer is expanded by heating to reduce the contact area with a wafer to facilitate the removal of the wafer.

When the wafer is directly removed from a hard plate, the possibility of breakage of a wafer is large. Accordingly, there is devised a method for preventing the breakage by applying a dicing sheet to be used in the next process, before the wafer is removed from the hard plate (Japanese Patent Laid-Open No. 2001-217212).

The heating for removing the wafer is conducted in an oven or the like, and at this time the dicing sheet is brought into contact with the bottom of the oven. As for the dicing sheet using conventional soft base materials, this may cause the base material to be melted or softened by the heating to cause the base materials to be adhered to the bottom of the oven.

However, when the pressure sensitive adhesive sheet of the present invention is used as a dicing sheet, neither a base material nor a top coat layer melts, and the top coat layer is hard to be softened, so that the pressure sensitive adhesive sheet will not cause fusion or adhesion on the bottom of the oven.

As a typical manufacturing, the semiconductor wafer is applied and fixed to a hard plate such as a glass plate using a heat-deformable double-sided pressure sensitive adhesive sheet. The wafer is subjected to backside grinding while fixed to the hard plate, and then a dicing sheet comprised of the pressure sensitive adhesive sheet of the present invention is applied to the wafer surface. When the wafer in this state is introduced into an oven for heating, the double-sided pressure sensitive adhesive sheet is deformed to remove the wafer from the double-sided pressure sensitive adhesive sheet, resulting in a state that the wafer is adhered only with the dicing sheet. This wafer is taken out of the oven, diced and then subjected to a predetermined packaging process to manufacture a semiconductor device.

In the above method, a manufacturing in which only a backside-grinding process is conducted on a hard plate has been described. However, a dicing process may be performed on the hard plate, following the backside-grinding process. In this case, the pressure sensitive adhesive sheet of the present invention may be, instead of a dicing sheet, a pressure sensitive adhesive sheet dedicated to the pickup process (pickup sheet). The pickup sheet refers to a pressure sensitive adhesive sheet that is applied to a wafer constructed in chip form, and is tailored to the function for picking up chips. Industrial Applicability

The present invention provides a pressure sensitive adhesive sheet that will not adhere to other apparatuses and the like even when applied to a manufacturing including heat treatment or treatment involving heat generation. The present invention further provides a pressure sensitive adhesive sheet for semiconductor wafer processing having unprecedented high-temperature heat resistance, which can be used as a surface protective sheet, a dicing sheet or a pickup sheet, by imparting properties such as protective function or expanding properties for circuit surfaces.

### [Examples]

The present invention will be described below with reference to Examples, but the present invention is not limited to these Examples. In the Examples and Comparative Examples below, the evaluation of "Young's modulus", "Surface roughness", "Stress relaxation ratio", "DSC peak amount", "High temperature adhesion" and "Wafer warpage" was made as follows:

### "Young's modulus"

The base materials of pressure sensitive adhesive sheets prepared in Examples or Comparative Examples were measured in accordance with JIS K-7127 at a test speed of 200 mm/minute.

### "Surface roughness"

The surfaces of top coat layers of pressure sensitive adhesive sheets prepared in Examples or Comparative Examples were measured for the average roughness (Rz) in accordance with JIS B-0601. Note that in Comparative Examples 1 and 3, the surfaces of base materials were measured.

### "Stress relaxation ratio"

Each laminate of a base material and a top coat layer prepared in Examples or Comparative Examples is cut to a width of 15 mm and a length of 100 mm to obtain a specimen. This specimen is elongated using TENSILON RTA-100 made by Orientec Corporation at a speed of 200 mm/minute, and the stress relaxation ratio is calculated from stress A at an elongation of 10% and stress B at one minute after the elongation according to the expression: (A-B)/A x 100 (%).

### "DSC peak amount"

The same formulations as the coating agents for the top coat layers of the pressure sensitive adhesive sheets prepared in Examples or Comparative Examples were dried and UV-cured to prepare samples for DSC measurement. A sample of about 10 mg was served for measurement, in which a differential scanning calorimeter (Pyris I made by Perkin Elmer, Inc.) was used for the measurement from room temperature to 220°C at a temperature increasing rate of 10°C/minute. The amount of energy of maximum heat absorption or heat generation occurring in the range of 50 to 200°C was defined as the DSC peak amount.

### "High temperature adhesion"

A pressure sensitive adhesive sheet (50 mm x 50 mm) of Examples or Comparative Examples was placed on a mirror-polished stainless steel plate with the top coat side facing the plate. The stainless steel plate with the pressure sensitive adhesive sheet was set and heated on a hot plate of 180°C for five minutes while applying a load of 100 g. The stainless steel plate was cooled at room temperature for one hour, and then turned upside down. When a pressure sensitive adhesive sheet freely fell, it was defined to be in a state of "not adhered," and when the pressure sensitive adhesive sheet could not freely fall, it was defined to be in a state of "adhered." Note that in Comparative Examples 1 and 3 the pressure sensitive adhesive sheet was placed on the stainless steel plate with the base material side facing the plate.

### "Wafer warpage"

A pressure sensitive adhesive sheet prepared in Examples and Comparative Examples was applied to a Silicon wafer having a diameter of 200 mm and a thickness of 725 µm, and the wafer was subjected to grinding to 100 µm. Subsequently, the wafer was set and heated on a hot plate of 180°C for five minutes with the pressure sensitive adhesive sheet side facing the hot plate. The wafer was cooled at room temperature for one hour without removing the pressure sensitive adhesive sheet, and placed on a wafer holding plate with the pressure sensitive adhesive sheet surface facing upward, leaving the wafer at rest. The height of the wafer was measured at 17 measurement points, defining the top surface of the wafer holding plate as the zero point, and the difference of the maximum and the minimum of the measurement values was defined as the amount of warpage.

### [Example 1]

1-1) Following formulations were used as an ultraviolet ray-curable coating agent for forming a top coat layer.
urethane acrylate oligomer (molecular weight (Mw) about 1,000): 50 parts by weight
dipentaerythritol hexaacrylate: 50 parts by weight
photoinitiator (IRGACURE 184 made by Ciba Specialty Chemicals Inc.): 4.0 parts by weight
silica filler (SNOWTEX-UP made by Nissan Chemical Industries Ltd.): 30 parts by weight
The above coating agent was coated using a Meyer bar on a casting film (SP-PET38E made by Lintec Corporation) made of a polyethylene terephthalate film (hereinafter referred to as a PET film) having a thickness of 38 µm being subjected release treatment with a silicone resin, cured by ultraviolet ray irradiation (250 mJ/cm²) to form a coating film of only a top coat layer having a thickness of 2 µm on the casting film.

1-2) Subsequently, following formulations were used as a coating agent for forming a base material.
urethane acrylate oligomer (molecular weight (Mw) about 5,000): 50 parts by weight
isobornyl acrylate: 50 parts by weight
photoinitiator (IRGACURE 184): 2.0 parts by weight

This coating agent was coated using a fountain die coater on the top coat layer on a casting film prepared in 1-1), cured by ultraviolet ray irradiation (250 mJ/cm²) to form a base material made of a cured coating film having a thickness of 157 µm on the top coat layer.

Next, an ultraviolet ray-curable pressure sensitive adhesive of following formulations was used as a coating agent for forming pressure sensitive adhesive layer.
an adduct product of 100 parts by weight of a copolymer (weight average molecular weight of about 500,000) consisting of 62 parts by weight of n-butyl acrylate, 10 parts by weight of methyl methacrylate and 28 parts by weight of hydroxyethyl acrylate, with 30 parts by weight of methacryloyloxyethyl isocyanate
0.3 parts by weight of photopolymerization initiator comprised of bis(2,4,6-trimethylbenzoyl)phenylphosphine oxide
0.3 parts by weight of a crosslinking agent comprised of an adduct product of tolylenediisocyanate with trimethylolpropane

This coating agent was coated on a release film (SP-PET3811(S)) manufactured by Lintec Corporation) made of a PET film having a thickness of 38 µm being subjected to release treatment with silicone resin, dried and transferred to the surface of the base material prepared in 1-2) on the side without the top coat, to thereby preparing a pressure sensitive adhesive sheet having a thickness of a pressure sensitive adhesive layer of 20 µm for protecting the circuit surface of a semiconductor wafer.

"Young's modulus", "Surface roughness", "Stress relaxation ratio", "DSC peak amount" and "High temperature adhesion" of the above pressure sensitive adhesive sheet are shown in Table 1. In addition, this pressure sensitive adhesive sheet was used at the grinding of a silicon wafer, and "Wafer warpage" was measured. The results are shown in Table 1.

The silicon wafer with the pressure sensitive adhesive sheet obtained in the above described method was placed on a heating table with the top coat layer of the pressure sensitive adhesive sheet facing the heating table, and a thermo-adhesive resin film (Adwill LP-3 made by Lintec Corporation) was applied to the ground surface of the silicon wafer at 180°C by thermo-compression bonding. The pressure sensitive adhesive sheet did not adhere to the heating table even after cooled to room temperature, and no warpage occurred to the silicon wafer. Moreover, no problem was observed when a gold (Au) film was formed by sputtering on the ground surface of another silicon wafer which was ground separately in the similar manner.

### [Example 2]

A pressure sensitive adhesive sheet was prepared in the same manner as in Example 1 except that BEAM SET 373A manufactured by Arakawa Chemical Industries Ltd. (a coating agent comprised of an acrylic polymer having an ultraviolet ray-curable functional group, which contains 20% by weight of a silica filler in solids) was used for preparing the top coat layer. The results are shown in Table 1.

In addition, no problem was observed either in the thermo-compression bonding of a thermo-adhesive resin film or in the formation of an Au film by sputtering performed in the same manner as in Example 1.

### [Comparative Example 1]

A pressure sensitive adhesive sheet was prepared in the same manner as in Example 1 except that a top coat layer was not formed in Example 1.

"Young's modulus", "Surface roughness", "Stress relaxation ratio" and "High temperature adhesion" of this pressure sensitive adhesive sheet are shown in Table 1. In addition, this pressure sensitive adhesive sheet was used at the grinding of a silicon wafer, and "Wafer warpage" was measured. The results are shown in Table 1.

In addition, the thermo-compression bonding of a thermo-adhesive resin film and the formation of an Au film by sputtering were performed in the same manner as in Example 1. Although no warpage of the wafer occurred in both cases, the pressure sensitive adhesive sheet adhered to the table and was hard to be released.

### [Comparative Example 2]

A pressure sensitive adhesive sheet was prepared in the same manner as in Example 1 except that a coating agent for a top coat layer was changed to a solution of 100 parts by weight of a non-crosslinkable polystyrene thermoplastic elastomer (no filler added) in a solvent.

"Young's modulus", "Surface roughness", "Stress relaxation ratio", "DSC peak amount" and "High temperature adhesion" of the above pressure sensitive adhesive sheet are shown in Table 1. In addition, this pressure sensitive adhesive sheet was used at the grinding of silicon wafers, and "Wafer warpage" was measured. The results are shown in Table 1.

In addition, the thermo-compression bonding of a thermo-adhesive resin film and the formation of an Au film by sputtering were performed in the same manner as in Example 1. Although no warpage of the wafer occurred in both cases, the pressure sensitive adhesive sheet adhered to the table and was hard to be released.

### [Comparative Example 3]

A pressure sensitive adhesive sheet was prepared in the same manner as in Example 1 except that a base material was changed to a. thermoplastic polyethylene terephthalate film having a thickness of 188 µm, and a top coat layer was not provided.

"Young's modulus", "Surface roughness", "Stress relaxation ratio" and "High temperature adhesion" of this pressure sensitive adhesive sheet are shown in Table 1. In addition, this pressure sensitive adhesive sheet was used at the grinding of a silicon wafer, and "Wafer warpage" was measured. The results are shown in Table 1.

In addition, the thermo-compression bonding of a thermo-adhesive resin film and the formation of an Au film by sputtering were performed in the same manner as in Example 1. The warpage of a wafer was observed in the both cases, and a part of the wafer broke.

### [Example 3]

A pressure sensitive adhesive sheet for dicing a semiconductor wafer was prepared in the same manner as in Example 1 except that the thickness of a base material was changed to 80 µm. "Young's modulus", "Surface roughness", "Stress relaxation ratio", "DSC peak amount" and "High temperature adhesion" of this pressure sensitive adhesive sheet are shown in Table 1.

In addition, the pressure sensitive adhesive sheet was used to fix a wafer having a diameter of 200 mm which is ground to a thickness of 200 µm to a wafer frame, and the wafer was diced to a size of 10 mm x 10 mm using a dicing apparatus. Subsequently, the wafer was heated by being placed on a hot plate of 180°C for five minutes with the top coat layer of the pressure sensitive adhesive sheet facing the hot plate. The wafer was cooled for one hour at room temperature, taken out of the hot plate, and was subjected to the ultraviolet ray irradiation (250 mJ/cm²) to the pressure sensitive adhesive layer from the top coat side of the pressure sensitive adhesive sheet. The pressure sensitive adhesive sheet was expanded by 10 mm using an expanding apparatus to increase the chip spacing, and the chip was subjected to pickup by pushing up with a needle from the pressure sensitive adhesive sheet side. All processes were operated with no problem, without adhesion of the pressure sensitive adhesive sheet to the hot plate.

### [Example 4]

A pressure sensitive adhesive sheet was prepared in the same manner as in Example 1 except that the coating agent for forming pressure sensitive layer was changed to an ultraviolet ray-curable pressure sensitive adhesive of the following formulation.
an adduct product of 100 parts by weight of a copolymer (weight average molecular weight of about 400,000) consisting of 60 parts by weight of 2-ethylhexyl acrylate and 40 parts by weight of 2-hydroxyethyl acrylate, with 48 parts by weight of 2-methacryloyloxyethyl isocyanate
0.2 parts by weight of photopolymerization initiator comprised of bis(2,4,6-trimethylbenzoyl)phenylphosphine oxide
0.3 parts by weight of a crosslinking agent comprised of an adduct product of tolylenediisocyanate with trimethylolpropane

The results are shown in the following table 1.

### [Example 5]

A pressure sensitive adhesive sheet was prepared in the same manner as in Example 2 except that the coating agent for forming pressure sensitive layer was changed to an ultraviolet ray-cutable pressure sensitive adhesive of the following formulation.
100 parts by weight of a copolymer (weight average molecular weight of about 600,000) consisting of 90 parts by weight of n-butyl acrylate and 10 parts by weight of acrylic acid
120 parts by weight of 6-functional urethane acrylate oligomer having weight average molecular weight of 760
0.2 parts by weight of photopolymerization initiator comprised of bis(2,4,6-trimethylbenzoyl)phenylphosphine oxide
15 parts by weight of a crosslinking agent comprised of an adduct product of tolylenediisocyanate with trimethylolpropane

The results are shown in the following table 1.

### [Example 6]

A pressure sensitive adhesive sheet was prepared in the same manner as in Example 2 except that the coating agent for forming pressure sensitive layer was changed to a removable pressure sensitive adhesive of the following formulation.
84 parts by weight of n-butyl acrylate
10 parts by weigh of methylmethacrylate
1 part by weight of acrylic acid
5 parts by weight of 2-hydroxyethyl acrylate
15 parts by weight of a crosslinking agent comprised of an adduct product of tolylenediisocyanate with trimethylolpropane

The results are shown in the following table 1.

**Table 1**

| | Base material | Top coat layer | | Stress relaxation ratio (%) | High temperature adhesion | Wafer warpage (mm) |
|---|---|---|---|---|---|---|
| | Young's modulus (MPa) | Surface roughness (µm) | DSC peak amount (J/g) | | | |
| Example 1 | 200 | 0.11 | < 0.02 | 87 | not adhered | 5 |
| Example 2 | 200 | 0.15 | < 0.02 | 87 | not adhered | 5 |
| Example 3 | 200 | 0.15 | < 0.02 | 87 | not adhered | - |
| Comparative Example 1 | 200 | 0.06 | - | 87 | adhered | 5 |
| Comparative Example 2 | 200 | 0.12 | 0.35 | 87 | adhered | 5 |
| Comparative Example 3 | 4900 | 0.04 | - | 30 | not adhered | 15 |
| Example 4 | 200 | 0.11 | < 0.02 | 87 | not adhered | 5 |
| Example 5 | 200 | 0.15 | < 0.02 | 87 | not adhered | 5 |
| Example 6 | 200 | 0.15 | < 0.02 | 87 | not adhered | 5 |

## Claims

1. A pressure sensitive adhesive sheet comprising a base material obtained by film-forming and curing a first curable resin, a top coat layer 0.2 to 20 µm thick formed on the base material by coating and curing a second curable resin, and a pressure sensitive adhesive layer formed on the opposite side of the base material, wherein a cured resin forming the top coat layer has no peak of 0.1 J/g or more in the DSC measurement from 50 to 200°C.

2. The pressure sensitive adhesive sheet according to claim 1, wherein said base material has a Young's modulus of 50 to 5,000 MPa.

3. A method for protecting the surface of a semiconductor wafer comprising the steps of applying the pressure sensitive adhesive sheet of claim 1 or 2 to the circuit surface of a semiconductor wafer having circuitry formed on the front side, and grinding the backside of the semiconductor wafer.

4. The method for protecting the surface of a semiconductor wafer according to claim 3, wherein a semiconductor wafer applied with a pressure sensitive adhesive sheet is subjected to heat treatment or treatment involving heat generation before or after grinding the semiconductor wafer.

5. The method for protecting the surface of a semiconductor wafer according to claim 4, wherein said heat treatment is thermo-compression bonding of a thermo-adhesive film on the ground side of a semiconductor wafer.

6. The method for protecting a semiconductor wafer according to claim 4, wherein the treatment involving heat generation is treatment selected from vacuum deposition, sputtering and plasma etching applied to the ground side of a semiconductor wafer.

7. A method for processing a workpiece comprising the steps of fixing a workpiece by the pressure sensitive adhesive sheet of claim 1 or 2 and picking up the workpiece.

8. The method for processing a workpiece according to claim.7, wherein a workpiece applied with a pressure sensitive adhesive sheet is subjected to heat treatment or treatment involving heat generation, before the picking up of the workpiece.

9. The method for processing a workpiece according to claim 8, wherein a workpiece fixed to a pressure sensitive adhesive sheet is applied with a thermo-adhesive film by thermo-compression bonding; the workpiece is diced together with the thermo-adhesive film; and then the diced workpiece is picked up and thermally adhered to a substrate via the thermo-adhesive film.

## Patentansprüche

1. Eine druckempfindliche Klebefolie umfassend ein Basismaterial, das durch Filmbildung und Härten eines ersten härtbaren Harzes erhalten wird, eine 0.2 bis 20 µm dicke obere Beschichtungsschicht, die durch Beschichten und Härten eines zweiten härtbaren Harzes auf dem Basismaterial gebildet wird, und eine druckempfindliche Klebeschicht, die auf der gegenüberliegenden Seite des Basismaterials gebildet wird, wobei ein gehärtetes Harz, das die obere Beschichtungsschicht bildet, keinen Spitzenwert von 0.1 J/g oder mehr in der DSC-Messung von 50 bis 200°C hat.

2. Die druckempfindliche Klebefolie nach Anspruch 1, wobei das Basismaterial ein Elastizitätsmodul von 50 bis 5000 MPa hat.

3. Ein Verfahren zum Schützen der Oberfläche von einem Halbleiterwafer umfassend die Schritte Aufbringen der druckempfindlichen Klebefolie nach Anspruch 1 oder 2 auf die Schaltkreisoberfläche von einem Halbleiterwafer mit einer Schaltung, die auf der Vorderseite ausgebildet ist, und Schleifen der Rückseite von dem Halbleiterwafer,

4. Das Verfahren zum Schützen der Oberfläche von einem Halbleiterwafer nach Anspruch 3, wobei ein Halbleiterwafer, auf dem eine druckempfindliche Klebefolie aufgebracht ist, einer Hitzebehandlung oder einer Behandlung ausgesetzt ist, die Hitzeerzeugung vor oder nach Schleifen des Halbleiterwafers umfasst.

5. Das Verfahren zum Schützen der Oberfläche von einem Halbleiterwafer nach Anspruch 4, wobei die Hitzebehandlung Thermokompressionsbonding von einem thermoadhäsiven Film auf der geschliffenen Seite von einem Halbleiterwafer ist.

6. Das Verfahren zum Schützen eines Halbleiterwafers nach Anspruch 4, wobei die Behandlung, die Hitzeerzeugung umfasst, eine Behandlung ist, die ausgewählt ist aus Vakuumbedampfen, Sputtern und Plasmaätzen, das auf der geschliffenen Seite von einem Halbleiterwafer angewendet wird.

7. Ein Verfahren zur Verarbeitung eines Arbeitsstücks, umfassend die Schritte Befestigen eines Arbeitsstücks mit der druckempfindlichen Klebefolie nach Anspruch 1 oder 2 und Aufnehmen des Arbeitsstücks.

8. Das Verfahren zur Verarbeitung eines Arbeitsstücks nach Anspruch 7. wobei ein Arbeitsstück, auf das eine druckempfindliche Klebefolie aufgebracht ist, einer Hitzebehandlung oder einer Behandlung ausgesetzt ist, die Hitzeerzeugung vor dem Aufnehmen des Arbeitsstücks umfasst.

9. Das Verfahren zur Verarbeitung eines Werkstücks nach Anspruch 8. wobei auf ein Werkstück, das an einer druckempfindlichen Klebefolie befestigt ist, ein thermoadhäsiver Film durch Thermokompressionsbonding aufgetragen wird; das Werkstück mit dem thermoadhäsiven Film zerlegt wird: und dann das zerlegte Werkstück aufgenommen und thermisch mit einem Substrat über den thermoadhäsiven Film verklebt wird.

## Revendications

1. Feuille autocollante comprenant un matériau de base obtenu par formation en une pellicule et durcissement d'une première résine durcissable, une couche de revêtement supérieure, d'une épaisseur de 0,2 à 20 µm, formée sur le matériau de base en appliquant un revêtement et en durcissant une deuxième résine durcissable, et une couche autocollante formée sur la face opposée du matériau de base dans laquelle une résine durcie formant la couche de revêtement supérieure n'a pas de pic supérieur ou égal à 0,1 J/g dans la mesure par DSC entre 50 et 200°C.

2. Feuille autocollante suivant la revendication 1, dans laquelle le matériau de base a un module d'Young de 50 à 5 000 MPa.

3. Procédé de protection de la surface d'une tranche à semi-conducteur, comprenant les stades d'application de la feuille autocollante de la revendication 1 ou 2 à la surface du circuit d'une tranche à semi-conducteur, ayant un circuit formé sur la face avant, et de polissage de la face arrière de la tranche à semi-conducteur.

4. Procédé de protection de la surface d'une tranche à semi-conducteur suivant la revendication 3, dans lequel on soumet une tranche à semi-conducteur, à laquelle est appliquée une feuille autocollante, à un traitement thermique ou à un traitement impliquant une production de chaleur, avant ou après le polissage de la tranche à semi-conducteur.

5. Procédé de protection de la surface d'une tranche à semi-conducteur suivant la revendication 4, dans lequel le traitement thermique est une liaison par thermocompression d'une pellicule thermo-adhésive sur la face polie d'une tranche à semi-conducteur.

6. Procédé de protection de la surface d'une tranche à semi-conducteur suivant la revendication 4, dans lequel le traitement impliquant une production de chaleur est un traitement choisi parmi un dépôt sous vide, une pulvérisation cathodique et une attaque au plasma appliqué à la face polie d'une tranche à semi-conducteur.

7. Procédé pour traiter une pièce comprenant le stade de fixation d'une pièce par la feuille autocollante de la revendication 1 ou 2 et de ramassage de la pièce.

8. Procédé de traitement d'une pièce suivant la revendication 7, dans lequel on soumet une pièce, à laquelle est appliquée la feuille autocollante, à un traitement thermique ou à un traitement impliquant une production de chaleur, avant de ramasser la pièce.

9. Procédé de traitement d'une pièce suivant la revendication 8, dans lequel on applique à une pièce fixée à une feuille autocollante une pellicule thermo-adhésive par liaison par thermocompression ; on découpe la pièce ensemble avec la pellicule thermo-adhésive et on ramasse la pièce découpée et on la fait adhérer thermiquement à un substrat par la pellicule thermo-adhésive.
